Europäisches Patentamt

European Patent Office

Office européen des brevets

(19)

(11) Veröffentlichungsnummer: **0 002 658**
**B 1**

(12) **EUROPÄISCHE PATENTSCHRIFT**

(45) Veröffentlichungstag der Patentschrift: **03.02.82**

(21) Anmeldenummer: **78101067.3**

(22) Anmeldetag: **04.10.78**

(51) Int. Cl.³: **H 01 L 21/208,**
**C 30 B 15/20 //H01L33/00**

(54) Verfahren zum Herstellen einer Halbleiteranordnung.

(30) Priorität: **22.12.77 DE 2757470**

(43) Veröffentlichungstag der Anmeldung:
**11.07.79 Patentblatt 79/14**

(45) Bekanntmachung des Hinweises auf die Patenterteilung:
**03.02.82 Patentblatt 82/5**

(84) Benannte Vertragsstaaten:
**DE FR GB NL**

(56) Entgegenhaltungen:
**DE - A - 2 626 775**
**Journal of Crystal Growth, Vol. 27, December**
**1974, Amsterdam, Holland,**
**E. Bauser et al.: "Substrate orientation and**
**surface morphology of GaAs liquid phase**
**epitaxial layers" Seiten 148 bis 153**

(73) Patentinhaber: **SIEMENS AKTIENGESELLSCHAFT**
**Berlin und München**
**Postfach 22 02 61**
**D-8000 München 22 (DE)**

(72) Erfinder: **Endler, Wolfgang**
**Burgmairstrasse 16**
**D-8000 München 21 (DE)**
Erfinder: **Westermeier, Heinz**
**Josef-Kyrein-Strasse 9C**
**D-8014 Neubiberg (DE)**
Erfinder: **Zschauer, Karl-Heinz, Dr.**
**Pf.-Dr.Rauch-Strasse 30**
**D-8018 Grafing (DE)**

Courier Press, Leamington Spa, England.

Verfahren zum Herstellen einer Halbleiteranordnung

Die Erfindung bezieht sich auf ein Verfahren zum Herstellen einer Halbleiteranordnung, insbesondere für optoelektronische Bauelemente, bei dem ein Substrat aus einer einkristallinen Halbleiterverbindung durch Epitaxie mit wenigstens einer Schicht aus einer weiteren Halbleiterverbindung versehen wird.

Bei optoelektronischen Bauelementen können die Leitungseigenschaften einer lichtemittierenden Schicht bekanntlich verbessert werden, indem diese Schicht zwischen Mischkristallen mit einem anderen Brechungsindex eingebaut wird. Mit solchen Heterostrukturen können die Verluste soweit begrenzt werden, daß man mit Schwellstromdichten von etwa $10^3$ A/cm² auskommt. Die Dicke der aktiven Zone sollte 1 $\mu$m nicht wesentlich überschreiten und vorzugsweise wesentlich geringer als 1 $\mu$m, insbesondere 0,2 $\mu$m, und weniger betragen. Bei diesen Bauelementen wird deshalb ein Substrat aus einer Halbleiterverbindung durch epitaktische Abscheidung mit weiteren Schichten aus der gleichen Halbleiterverbindung oder einer anderen Halbleiterverbindung, beispielsweise einem Mischkristall mit nahezu der gleichen Gitterkonstante, versehen, die einen Heteroübergang bildet. Beispielsweise zur Verbesserung der Eigenschaften von Halbleiter-Lasern, wie Schwellstrom und Resonator-Geometrie, und zur Begrenzung der Verluste sind solche dünnen Schichten mit gleichmäßiger Schichthöhe und ebener Oberfläche ohne Kristallstörungen erforderlich.

Diese Forderung muß auch bei der Herstellung anderer elektronischer Bauelemente erfüllt sein, bei denen dünne Schichten von Verbindungshalbleitern durch epitaktische Abscheidung hergestellt werden, beispielsweise bei den elektronischen Bauelementen mit Lawinen-Effekt, wie den Lawinen-Photodioden und den Lawinen-Laufzeitdioden. Diese Dioden enthalten einen gleichrichtenden Übergang, der in Sperrichtung betrieben wird. Der Wirkungsgrad dieser Bauelemente wird wesentlich bestimmt vom Durchbruchsverhalten des pn-Übergangs und damit von der Homogenität des Durchbruchsbereichs. Ferner müssen die erwähnten Forderungen, beispielsweise bei der Herstellung von Mikrowellen-Feldeffekttransistoren, erfüllt sein, bei denen bekanntlich auf einem Substrat aus einem Verbindungshalbleiter, beispielsweise mit Chrom dotiertem Galliumarsenid, eine als Diffusionssperre dienende Zwischenschicht und dann eine aktive n-leitende Epitaxie-schicht abgeschieden wird. Auf der aktiven Schicht werden dann die Elektroden angebracht.

Der Erfindung liegt deshalb die Aufgabe zugrunde, Verfahrensschritte anzugeben, mit denen die Oberfläche eines Verbindungshalbleiters durch epitaktische Abscheidung mit wenigstens einer dünnen Schicht versehen werden kann, die gleichmäßige Dicke hat und ohne Kristallstörungen ist.

Bekanntlich können bereits geringe Abweichungen von der gleichmäßigen Dicke der durch Epitaxie, insbesondere durch Flüssigphasenepitaxie (liquid phase epitaxie, LPE), abgeschiedenen dünnen Schichten die Qualität der entstehenden Bauelemente vermindern. Epitaxieschichten, die auf einer Kristalloberfläche aufwachsen, deren Fehlorientierung $\Delta\varphi$ etwa 30 min beträgt, zeigen Terrassenstrukturen der aufgewachsenen Schicht. Dagegen erhält man eine flache und ebene Epitaxieschicht, wenn die Fehlorientierung der Substratoberfläche kleiner ist als 5 min (Journal of Crystal Growth, 27(1974), Seiten 148—153). Die erwähnten Forderungen können somit erfüllt werden, wenn die Schichten auf einer völlig ebenen Oberfläche eines Substrats mit singulären Kristallflächen ohne Fehlorientierungen aufwachsen.

Solche Halbleiteroberflächen sind aber nur mit einem verhältnismäßig großen Aufwand herzustellen.

Es ist ferner bekannt, daß gerade bei Lasern mit einer Schichtenfolge von Halbleiterverbindungen in Doppelheterostruktur die durch leichte zufällige Fehlorientierungen der Substrat-Oberfläche verursachten Wachstumsterrassen die Streulichtverluste erhöhen und durch die entsprechenden Schwankungen in der Schichtdicke die Wirksamkeit des aktiven Volumens der Schichten vermindern und daher zur Erhöhung der Schwellspannung beitragen (Journal of Applied Physics, Vol. 47, Nr. 9, Sept. 1976, Seiten 3992 bis 4005).

Die genannte Aufgabe wird bei einem Verfahren der eingangs gennannten Art erfindungsgemäß dadurch gelöst, daß die Oberfläche des Substrats vor Ausführung der Epitaxie mit einer eine Facettenstruktur bildenden Vielzahl von Mesa-Bergen in vorbestimmter Verteilung versehen wird.

Die Erfindung beruht auf der Erkenntnis, daß die erwähnten Forderungen an die Struktur der dünnen Epitaxieschichten in einfacher Weise erfüllt werden können, wenn die Epitaxieschicht auf dem Substrat als Wachstumsterrasse gebildet wird, die in sich geschlossen ist und dadurch eine solche Facettenstruktur bildet. Es wurde nämlich erkannt, daß die Oberfläche der Facettenstruktur annähernd singulär und eben ist. Außerdem hat die Facettenstruktur eine hohe Stabilität, d.h. bei der Abscheidung einer weiteren Schicht bleibt die facettenartige Oberfläche erhalten.

Die Facettenstrukturen erhält man vorzugsweise dadurch, daß zunächst definierte Oberflächenbereiche mit unterschiedlicher Fehlorientierung gebildet werden und dann die Anisotropie des Kristallwachstums an den Kanten der Wachstumsterrassen ausgenutzt wird, indem ein kritischer Übersättigungsbereich der abzuscheidenden Halbleiterverbindung gewählt wird, in dem die Anisotropie des Wachstums verstärkt auftritt. Diese Oberflächenbereiche erhält man in einfacher Weise dadurch, daß die gesamte Oberfläche, auf die anschließend die folgende Schicht abzuscheiden ist, mit einer Vielzahl von Mesa-Bergen in einer vorbestimmten Verteilung versehen wird. Die Verteilung der Mesa-Berge wird so gewählt, daß die gesamte Anordnung nach der Fertigstellung der Doppelheterostruktur so zerteilt werden kann, daß jedes entstehende Teilstück eine der Facetten enthält. Die Herstellung der Mesa-Berge erfolgt beispielsweise durch Photolack-Technik mit anschließender Ätzung. Dieser Herstellungsprozeß ist in der Halbleitertechnik bekannt als Photolithographie.

Auf der so vorbereiteten Oberfläche des Substrats wird die Halbleiterverbindung vorzugsweise durch Flüssigphasenepitaxie mit linearer Abkühlung und geringer Abschiedungsgeschwindigkeit abgeschieden. Die Abscheidung erfolgt vorzugsweise aus einer Lösung der Halbleiterverbindung, deren Übersättigung zu Beginn der Abscheidung an der Phasengrenze nicht mehr als 3%, vorzugsweise höchstens 1%, insbesondere höchstens 0,3%, beträgt. Die Abkühlungsrate wird höchstens 3 K/min, vorzugsweise höchstens 1 K/min, gewählt und kann insbesondere etwa 0,3 K/min betragen.

Die Form der Mesa-Berge wird bestimmt durch die Art des entsprechenden Bauelementes. Vorzugsweise werden sie hergestellt als Kreisscheibe und können u.U. auch quadratisch sowie rechteckig sein. Bei diesen Mesaberg-Formen wird die Flächenausdehnung der Bergkuppen, d.h. der Durchmesser bzw. die Kantenlänge der Kuppen mehrere mm nicht wesentlich überschreiten und vorzugsweise bis zu etwa 1200 $\mu$m, insbesondere etwa 200 bis 500 $\mu$m betragen. Mit diesen Mesa-Bergkuppen erhält man durch das anisotrope Wachstum der epitaktisch aufwachsenden Schicht jeweils eine Facette, deren Durchmesser bis zum doppelten Durchmesser des zugeordneten Mesa-Berges und mehr betragen kann.

Bei vorbestimmter Auswahl der Lagenorientierung länglicher Strukturen sind auch größere Flächenausdehnungen, beispielsweise in langgestreckter Form, vorstellbar.

Zur weiteren Erläuterung der Erfindung wird auf die Zeichnung Bezug genommen, in deren Fig. 1 die Verfahrensschritte zur Herstellung einer Halbleiteranordnung schematisch veranschaulicht sind. Fig. 2 zeigt ein Ausführungsbeispiel einer mit dem Verfahren nach der Erfindung hergestellten Epitaxieschicht. In Fig. 3 ist eine Halbleiteranordnung mit einer Folge von Epitaxieschichten, die mit dem Verfahren nach der Erfindung hergestellt sein kann, schematisch dargestellt.

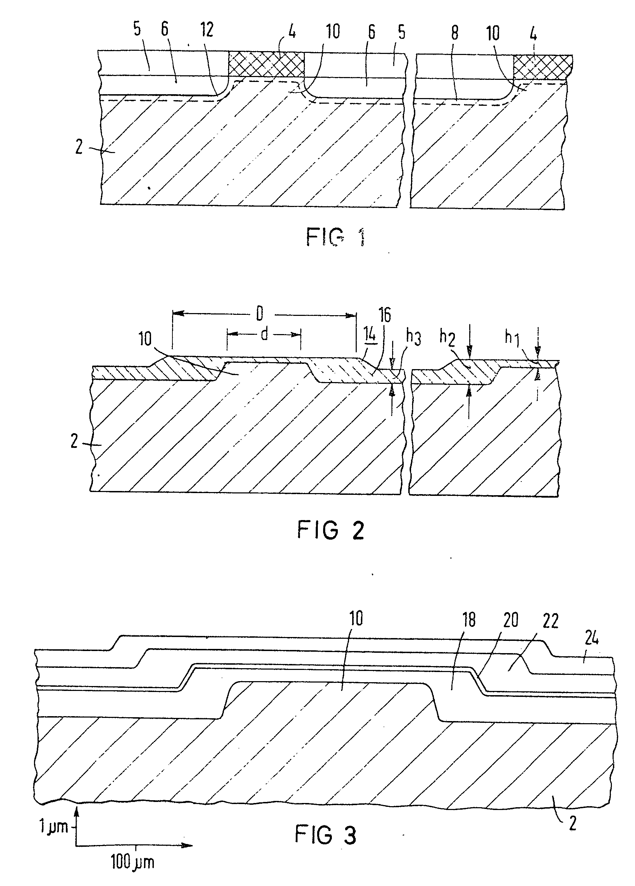

Nach Fig. 1 ist ein Substrat 2 aus einer Halbleiterverbindung, beispielsweise n-leitendem GaAs, auf seiner oberen Flachseite mit einer Photolackschicht 4 versehen. Von dieser Photolackschicht 4 werden in bekannter Technik Teile 5 entfernt, so daß in der Schicht 4 Freiräume entstehen. Anschließend wird in diesen Freiräumen ein Teil 6 der Oberflächenschicht des Substrats 2 abgetragen, beispielsweise durch Ätzen. Dann werden die Teile 4 der Photolackschicht entfernt und damit auf der Oberfläche des Substrats 2 Mesa-Berge 10 freigelegt, die auf der gesamten Oberfläche des Substrats vorzugsweise in der Form eines Rasters verteilt sein können. Diese Verteilung erleichtert später die Aufteilung der gesamten Anordnung in Einzelanordnungen mit jeweils einem einzigen Mesa-Berg 10 und den darauf abgeschiedenen weiteren Epitaxieschichten. Unter Umständen kann es zweckmäßig sein, die freie Oberfläche des Substrats 2 anschließend noch einer Überätzung zu unterziehen, mit der die Kanten an den oberen Flachseiten der Mesa-Berge 10 etwas abgerundet werden. Durch diese Überätzung wird nämlich noch eine dünne Oberflächenschicht 12 von dem Substrat 2 abgetragen. Das Substrat 2 erhält somit eine Form der Oberfläche, wie sie in der Figur gestrichelt angedeutet ist.

Auf einer derartigen Oberfläche des Substrats 2 können weitere Epitaxieschichten ohne weitere Vorbereitung abgeschieden werden. Das Substrat 2 wird nach Fig. 2 mit einer Epitaxieschicht 12 einer Halbleiterverbindung, beispielsweise n-leitendem (GaAl)As, das mit dem Substrat einen Heteroübergang bildet. Diese Epitaxieschicht 12 erhält man vorzugsweise durch Flüssigphasenepitaxie bei linearer Abkühlung mit einer Abkühlungsrate von vorzugsweise etwa 0,3 K/min. Schon nach wenigen Sekunden bilden sich auf dem kreisscheibenförmigen Mesa-Berg 10 kleine Facetten die sich mit vorschreitender Wachstumsdauer weit über die Ausdehnung d des ursprünglichen Mesa-Berges 10 hinaus vergrößern. Die Oberfläche der einzelnen Facetten erscheint im Phasenkontrastmikroskop völlig glatt und eben und zeigt praktisch keine Wachstumsstörungen wie beispielsweise Benetzungsfehler. Die Facette wächst in lateraler Richtung wesentlich stärker als in vertikaler Richtung. Zur Verdeutlichung ist der senkrechte Maßstab in Fig. 2 etwa 25-fach größer als der Maßstab in lateraler Richtung gewählt. Die laterale Wachstumsgeschwindigkeit übertrifft die vertikale Wachstumsgeschwindigkeit etwa um zwei Größenordnungen. Das Wachstum auf der Facettenoberfläche wird derart gehemmt, daß die Höhe $h_1$ der Epitaxieschicht auf dem Mesa-Berg 10 wesentlich geringer ist als die nach der Diffusionstheorie zu erwartende Höhe $h_3$ der Epitaxieschicht zwischen den Mesa-Bergen 10. An den Kanten des Mesa-Berges 10 wächst die Epitaxieschicht 12 bis zur Höhe $h_2$. Sobald diese

Höhe $h_2$ erreicht ist, erfolgt das weitere Wachstum in senkrechter Richtung nur noch mit der wesentlich geringeren Geschwindigkeit, so daß sich am Ende der Abscheidung eine Facette 14 gebildet hat, deren obere Flachseite eben ist und von einer singulären Kristallfläche gebildet wird. Beispielsweise erhält man beim Aufwachsen einer Facette 14 nach einer Wachstumsdauer von etwa 20 min auf einem Mesa-Berg mit einem Durchmesser der Kuppe von d=300 $\mu$m eine Facette 14 mit einem Durchmesser D von etwa 600 $\mu$m, eine Schichthöhe $h_1$ über dem Mesa-Berg 10 von etwa 1 $\mu$m und eine Dicke $h_2$ des äußeren Teils der Facette 14 von etwa 4,5 $\mu$m und eine Höhe $h_3$ der Epitaxieschicht zwischen den Facetten 14 von etwa 2,5 $\mu$m. Dieses für die Bildung der Facette 14 erforderliche anisotrope Wachstum der Epitaxieschicht 16 erhält man mit einer sehr geringen Übersättigung der flüssigen Phase der Halbleiterverbindung.

Beim Abscheiden weiterer Schichten bleibt die Form der Facette 14 erhalten, d.h. die Facette 14 wächst mit hoher lateraler und geringer vertikaler Geschwindigkeit weiter. Dadurch lassen sich in einfacher Weise Mehrschichtstrukturen nach Fig. 3 herstellen, wie sie beispielsweise für die GaAs-Laserdiode benötigt werden. In der Ausführungsform einer Laserdiode in Doppelheterostruktur nach Fig. 3 ist das Substrat 2, beispielsweise aus n-leitendem Gallium-Arsenid GaAs, mit einem Mesa-Berg 10 versehen. Auf der oberen Flachseite des Substrats 2 ist eine Halbleiterverbindung, beispielsweise aus n-leitendem GaAlAs, abgeschieden, die mit dem Substrat 2 einen Heteroübergang bildet. Die Abscheidung erfolgt vorzugsweise durch Flüssigphasenepitaxie mit linearer Abkühlung und sehr geringer Übersättigung der flüssigen Halbleiterverbindung. Die abgeschiedene Epitaxieschicht 18 bildet eine Facette mit wesentlich größerem Durchmesser als der Mesa-Berg 10. Zur Vereinfachung ist deshalb auch in dieser Figur der laterale gegenüber dem vertikalen Maßstab etwa 25-fach vergrößert.

Auf der Epitaxieschicht 18 wird eine weitere Schicht 20 aus p-leitendem Ga-Al-As abgeschieden, die sehr dünn ist und die aktive Schicht einer Laserdiode bilden soll. Auf dieser aktiven Schicht 20 wird eine weitere Schicht 22 aus p-leitendem Ga-Al-As und darauf nochmals eine Epitaxieschicht 24 aus p-leitendem Ga-As abgeschieden, die mit der Schicht 22 wiederum einen Heteroübergang bildet.

Nach der Fertigstellung der erforderlichen Mehrschichtstruktur erhält man die Ausgangsanordnung für ein einzelnes Bauelement durch Aufteilung der gesamten Anordnung in Einzelteile, die jeweils eine einzelne Facette auf dem Substrat 2 enthalten. Diese Aufteilung ist in der Figur an den seitlichen Endflächen durch Brechkanten angedeutet. Zur Abscheidung der Schichten 18, 20, 22 und 24 der Mehrschichtstruktur ist vorzugsweise die Flüssigphasenepitaxie geeignet. Die Schichten können jedoch auch aus der Gasphase abgeschieden werden.

Das Verfahren nach der Erfindung wurde erläutert anhand der Herstellung einer Mehrschichtstruktur für die GaAs-Laserdiode. Das Verfahren kann jedoch bei allen Bauelementen mit epitaktisch abgeschiedenen Schichten angewendet werden, bei denen die Epitaxieschichten eben und frei von Kristallstörungen sein müssen.

## Patentansprüche

1. Verfahren zum Herstellen einer Halbleiteranordnung, insbesondere für optoelektronische Bauelemente, bei dem ein Substrat aus einer einkristallinen Halbleiterverbindung durch Epitaxie mit wenigstens einer Schicht aus einer weiteren Halbleiterverbindung versehen wird, dadurch gekennzeichnet, daß die Oberfläche des Substrats (2) vor Ausführung der Epitaxie mit einer eine Facettenstruktur bildenden Vielzahl von Mesa-Bergen (14) in vorbestimmter Verteilung versehen wird.

2. Verfahren nach Anspruch 1, dadurch gekennzeichnet, daß die wenigstens annähernd parallel zu einer singulären Kristallfläche des Substrats (2) orientierte Oberfläche durch Abtragung einer Oberflächenschicht (6) in einem vorbestimmten Oberflächenbereich mit den Mesa-Bergen (10) versehen wird, deren flache Kuppen jeweils von einem Teil der Oberfläche des Substrats (2) gebildet werden.

3. Verfahren nach Anspruch 2, gekennzeichnet durch Überätzen der mit Mesa-Bergen (10) versehenen Oberfläche des Substrats (2).

4. Verfahren nach einem der Ansprüche 1 bis 3, dadurch gekennzeichnet, daß auf der vorverarbeiteten Oberfläche des Substrats (2) die Halbleiterverbindung durch Flüssigphasenepitaxie mit linearer Abkühlung und geringer Abscheidungsgeschwindigkeit abgeschieden wird.

5. Verfahren nach Anspruch 4, gekennzeichnet durch Abscheidung aus einer Lösung der Halbleiterverbindung, deren Übersättigung am Anfang der Abscheidung an der Phasengrenze nicht mehr als 3% beträgt.

6. Verfahren nach Anspruch 5, dadurch gekennzeichnet, daß die Übersättigung höchstens 1% betragt.

7. Verfahren nach Anspruch 6, dadurch gekennzeichnet, daß die Übersättigung höchstens 0,3% beträgt.

8. Verfahren nach einem der Ansprüche 4 bis 7, dadurch gekennzeichnet, daß die Abkühlungsrate höchstens 1 K/min beträgt.

9. Verfahren nach Anspruch 8, dadurch gekennzeichnet, daß die Abkühlungsrate etwa 0,3 K/min beträgt.

10. Verfahren nach einem der Ansprüche 1 bis 9, dadurch gekennzeichnet, daß die Flächenausdehnung der Kuppen der Mesa-Berge bis zu mehreren Millimetern gewählt wird.

11. Verfahren nach Anspruch 10, dadurch gekennzeichnet, daß die Flächenausdehnung der Kuppen der Mesa-Berge bis zu etwa 1200 μm gewählt wird.

12. Verfahren nach Anspruch 11, dadurch gekennzeichnet, daß die Flächenausdehnung der Kuppen der Mesa-Berge etwa 200 bis 500 μm gewählt wird.

## Claims

1. A process for the production of a semiconductor arrangement, particularly for optoelectronic components, in which a substrate consisting of a monocrystalline semiconductor compound is provided by means of epitaxy with at least one layer consisting of a further semiconductor compound, prior to carrying out the epitaxy, the surface of the substrate (2) is provided with a plurality of mesa-shaped peaks (10) having a predetermined spacing and forming a facetted structure.

2. A process as claimed in Claim 1, characterised in that a surface which is orientated at least approximately parallel to a particular crystal surface of the substrate (2), is provided with the mesa-shaped peaks (10) by removing a surface layer (6) in a predetermined surface zone, the flat tops of the mesa-shaped peaks (10) each being formed by a part of the surface of the substrate (2).

3. A process as claimed in Claim 2, characterised by overetching of the surface of the substrate (2) which is provided with mesa-shaped peaks (10).

4. A process as claimed in one of Claims 1 to 3, characterised in that on the prepared surface of the substrate (2), the semiconductor compound is deposited by liquid phase epitaxy with linear cooling and a low rate of deposition.

5. A process as claimed in Claim 4, characterised by deposition from a solution of the semiconductor compound, the supersaturation of which is not more than 3% at the phase boundary, at the beginning of the deposition.

6. A process as claimed in Claim 5, characterised in that the supersaturation is at most 1%.

7. A process as claimed in Claim 6, characterised in that the supersaturation is at most 0.3%.

8. A process as claimed in one of Claims 4 to 7, characterised in that the rate of cooling is at most 1 K/min.

9. A process as claimed in Claim 8, characterised in that the rate of cooling is approximately 0.3 K/min.

10. A process as claimed in one of Claims 1 to 9, characterised in that the surface dimension of the tops of the mesa-shaped peaks is up to several millimeters.

11. A process as claimed in Claim 10, characterised in that the surface dimension of the tops of the mesa-shaped peaks is up to approximately 1200 μm.

12. A process as claimed in Claim 11, characterised in that the surface dimension of the tops of the mesa-shaped peaks is approximately 200 to 500 μm.

## Revendications

1. Procédé pour la fabrication d'un dispositif à semiconducteurs, plus particulièrement pour des composants optoélectroniques, dans lequel un substrat d'un composé semiconducteur monocristallin est pourvu, par épitaxie, d'au moins une couche d'un second composé semiconducteur, caractérisé par le fait que la surface du substrat (2) est pourvue, avant la réalisation de l'épitaxie, d'un grand nombre de plateaux Mesa (14) disposés selon und distribution prédéterminée et formant une structure à facettes.

2. Procédé selon la revendication 1, caractérisé par le fait que la surface orientée au moins à peu près parallèlement à la surface singulière du cristal du substrat (2) est pourvue, par photogravure négative, d'une couche superficielle (6) dans une zone superficielle prédéterminée des plateaux Mesa (10) dont les cimes plates sont formées chacune par une partie de la surface (2) du substrat.

3. Procédé selon la revendication 2, caractérisé par une attaque prononcée de la surface du substrat pourvue des plateaux Mesa (10).

4. Procédé selon l'une des revendications 1 à 3, caractérisé e par le fait que sur la surface prétraitée du substrat (2), le composé semiconducteur est déposé par épitaxie en phase liquide, avec refroidissement linéaire et vitesse de dépôt réduite.

5. Procédé selon la revendication 4, caractérisé par un dépôt à partir d'une solution du composé semiconducteur dont la sursaturation, au début du dépôt n'est pas supérieure à 3%, à la limite de la phase.

6. Procédé selon la revendication 5, caractérisé par le fait que la sursaturation est au maximum de 1%.

7. Procédé selon la revendication 6, caractérisé par le fait que la sursaturation est au maximum de 0,3%.

8. Procédé selon l'une des revendications 4 à 7, caractérisé par le fait que la vitesse de refroidissement est au maximum égale à 1 K/minute.

9. Procédé selon la revendication 8, caractérisé par le fait que la vitesse de refroidissement est d'environ 0,3 K/minute.

10. Procédé selon l'une des revendications 1 à 9, caractérisé par le fait que l'extension en surface des cimes des plateaux Mesa est choisie jusqu'à plusieurs millimètres.

11. Procédé selon la revendication 10, caractérisé par le fait que l'extension en surface des cimes des plateaux Mesa est choisie jusqu'à environ 1200 μm.

12. Procédé selon la revendication 11, caractérisé par le fait que l'extension en surface des cimes des plateaux Mesa est choisie à environ 200 à 500 $\mu$m.

FIG 1

FIG 2

FIG 3

1 µm

100 µm